(19) Europäisches Patentamt
European Patent Office
Office européen des brevets

(11) **EP 1 389 796 B1**

(12) **EUROPÄISCHE PATENTSCHRIFT**

(45) Veröffentlichungstag und Bekanntmachung des Hinweises auf die Patenterteilung:
**03.06.2009 Patentblatt 2009/23**

(51) Int Cl.:
*H01J 37/153* (2006.01)  *H01J 37/10* (2006.01)
*H01J 37/147* (2006.01)  *H01J 37/317* (2006.01)
*H01J 37/28* (2006.01)

(21) Anmeldenummer: **03018255.4**

(22) Anmeldetag: **11.08.2003**

(54) **Teilchenoptische Vorrichtung und Verfahren zum Betrieb derselben**

Particle optical device and method for its operation

Dispositif d'optique corpusculaire et méthode pour son opération

(84) Benannte Vertragsstaaten:
**CZ DE FR GB IT NL**

(30) Priorität: **13.08.2002 DE 10237135**

(43) Veröffentlichungstag der Anmeldung:
**18.02.2004 Patentblatt 2004/08**

(73) Patentinhaber: **Carl Zeiss NTS GmbH**
**73447 Oberkochen (DE)**

(72) Erfinder: **Knippelmeyer, Rainer, Dr.**
**73431 Aalen (DE)**

(74) Vertreter: **Diehl, Hermann O. Th.**
**Diehl & Partner**
**Augustenstrasse 46**
**80333 München (DE)**

(56) Entgegenhaltungen:
WO-A-01/22469  US-A1- 2001 028 044
US-A1- 2002 054 284

- SCHMID PETER ET AL: "Outline of a variable-axis lens with arbitrary shift of the axis in one direction" JOURNAL OF VACUUM SCIENCE AND TECHNOLOGY. B, MICROELECTRONICS AND NANOMETER STRUCTURES PROCESSING, MEASUREMENT AND PHENOMENA, AMERICAN INSTITUTE OF PHYSICS, NEW YORK, NY, US, Bd. 19, Nr. 6, November 2001 (2001-11), Seiten 2555-2565, XP012009084 ISSN: 1071-1023
- MOONEN D ET AL: "Design of an Electron Projection System with Slider Lenses and Multiple Beams" PROCEEDINGS OF SPIE, Bd. 4688, 5. Juli 2002 (2002-07-05), XP002328504

**Beschreibung**

Die Erfindung betrifft eine teilchenoptische Vorrichtung und ein Verfahren zum Betrieb derselben.

Die teilchenoptische Vorrichtung ist dazu vorgesehen, einen Strahl geladener Teilchen zu beeinflussen, wie etwa zu führen und zu formen, insbesondere abzulenken oder/und wenigstens in einer Ebene zu fokussieren oder zu defokussieren.

Insbesondere betrifft die Erfindung auch ein Mikroskopiesystem und ein Lithographiesystem, welche Strahlen geladener Teilchen, insbesondere Elektronenstrahlen, zur Abbildung von Strukturen einsetzen.

Aus WO 01/22469 A1 ist eine teilchenoptische Vorrichtung bekannt, welche auf einen Strahl geladener Teilchen eine Wirkung einer fokussierenden Rundlinse aufweist, wobei eine optische Achse der Rundlinse quer zur Richtung des Strahls verlagerbar ist. Hierzu umfaßt die Vorrichtung zwei zueinander parallele und mit Abstand voneinander angeordnete Reihen von Feldquellelementen, wobei in einer jeden Reihe die Feldquellelemente in einer Reihenrichtung periodisch mit Abstand voneinander angeordnet sind. Quellstärken der Feldquellelemente werden derart eingestellt, daß zwischen den beiden Reihen von Feldquellelementen ein Quadrupolfeld zur Beeinflussung des Strahls bereitgestellt ist. Dieses Quadrupolfeld wirkt zusammen mit einem durch Schlitzblenden bereitgestellten Zylinderlinsenfeld derart, daß der Teilchenstrahl bezüglich einer durch eine Lage des Quadrupolfeldes in Reihenrichtung festgelegten optischen Achse fokussiert wird. Durch Verlagerung des Quadrupolfeldes in Reihenrichtung ist es möglich, die optische Achse der fokussierenden Wirkung ebenfalls in Reihenrichtung zu verlagern.

Es hat sich gezeigt, daß die optischen Eigenschaften dieser herkömmlichen teilchenoptischen Vorrichtung als unzureichend empfunden wurden.

Entsprechend ist es eine Aufgabe der vorliegenden Erfindung, diese herkömmliche teilchenoptische Vorrichtung bzw. ein Verfahren zu deren Betrieb derart weiterzubilden, daß bessere teilchenoptische Eigenschaften erzielbar sind.

Die Aufgabe wird durch eine Vorrichtung nach Anspruch 1 sowie ein Verfahren nach Anspruch 7 gelöst.

Unter einem ersten Aspekt geht die Erfindung aus von einer teilchenoptischen Vorrichtung der eingangs geschilderten Art, wobei für einen jeden Strahl geladener Teilchen zwischen den beiden Reihen von Feldquellelementen ein Bereich bereitgestellt ist, in dem die Feldquellelemente ein Feld zur Beeinflussung des jeweiligen Strahls erzeugen.

Hierbei haben die Erfinder herausgefunden, daß die Feldbereiche, welche in einer Reihe von Feldbereichen zwischen einander benachbarten Feldbereichen angeordnet sind, besonders reproduzierbare und von einer Verlagerung unabhängige optische Eigenschaften auf die diese Bereiche durchsetzenden Strahlen bereitstellen. Feldbereiche, welche hingegen am Rand einer solchen Reihe liegen, zeigten optische Eigenschaften, welche sich mit einer Verlagerung der Feldbereiche in Reihenrichtung änderten.

Entsprechend schlägt die Erfindung unter diesem Aspekt vor, neben einem Feldbereich, welcher am Ende einer Reihe von Feldbereichen zur Beeinflussung einer Reihe von Strahlen liegt, noch einen weiteren Feldbereich vorzusehen, obwohl dieser weitere Feldbereich nicht zur Ablenkung eines Strahls nötig ist. Dieser weitere Feldbereich stellt ein ähnliches Feld bereit, wie die Feldbereiche innerhalb der Reihe, so daß die ursprünglich am Ende der Reihe von Feldbereichen liegenden Feldbereiche nun in einer ähnlichen Feldumgebung angeordnet sind, wie die nicht am Ende einer Reihe von Feldbereichen angeordneten Feldbereiche. Somit werden sämtliche Strahlen der Reihe im wesentlichen gleich beeinflußt.

Unter einem weiteren Aspekt, der jedoch keine Ausfürungsform der Erfindung ist, wird von einem Verfahren ausgegangen, bei dem zur Beeinflussung des Strahls geladener Teilchen Quellstärken der Feldquellelemente durch ein Muster bzw. eine ortsabhängige Funktion repräsentiert sind, wobei zur Verlagerung der Wirkung auf den Strahl in Reihenrichtung dieses Muster bzw. die ortsabhängige Funktion ebenfalls in Reihenrichtung verlagert wird.

Die Erfinder haben herausgefunden, daß die nach der Verlagerung bereitgestellte Beeinflussung des Strahls dann mit der Beeinflussung des Strahls vor der Verlagerung des Musters bzw. der ortsabhängigen Funktion besonders gut übereinstimmt, wenn die Verlagerung die Größe eines ganzzahligen Vielfachen der Anordnungsperiode der Feldquellelemente in Reihenrichtung aufweist. Weichen die Verlagerungen von diesen ganzzahligen Vielfachen der Anordnungsperioden ab, so ergeben sich aufgrund der durch die begrenzte Zahl von Feldquellelemente notwendigen Diskretisierung Abweichungen zwischen der Wirkung des unverlagerten Feldes und der Wirkung des verlagerten Feldes. Die vorliegende Oftenbarung schlägt hier dann weitere Beispiele die keine Ausführungsformen der Erfindung sind vor, in welchen die Quellstärken nicht nur in Abhängigkeit von dem verlagerten Muster bzw. der verlagerten ortsabhängigen Funktion eingestellt werden, sondern daß ferner noch Korrekturterme in die Bestimmung der Quellstärken eingehen. Diese Korrekturterme sind im wesentlichen Null, wenn die Verlagerung ein ganzzahliges Vielfaches der Anordnungsperiode der Feldquellelemente in der Reihe ist, und sie können von Null verschieden sein, wenn die Verlagerung verschieden ist von einem ganzzahligen Vielfachen dieser Anordnungsperiode.

In den beschriebenen Ausführungsformen ist immer einem Strahl ein Feldbereich zugeordnet, welcher für die Beeinflussung des Strahls ein Feld einer stetigen Geometrie, wie beispielsweise eine Quadrupolsymmetrie, bereitstellt. Es ist jedoch auch vorgesehen, einen solchen Feldbereich für die Beeinflussung einer Gruppe von Strahlen vorzusehen, wie dies beispielsweise in der europäischen Patentanmeldung EP 1 385 192 A2 der Anmelderin beschrieben ist, beispielsweise im Zusammenhang mit Figur 6 jener Anmeldung.

Schmid et al., J. Vac. Sci. Technol. B 19(6), 2555-2565 (2001) offenbart eine teilchenoptische Vorrichtung bzw. ein Verfahren zum Betrieb einer solchen mit einer Linse mit beliebiger Verschiebbarkeit der Linsenachse in einer Richtung nach dem Oberbegriff der jeweiligen unabhängigen Ansprüche.

US2001/0028044 A1 offenbart einen Elektronenstrahl-Belichtungsapparat mit "dummy openings", durch welche kein Elektronenstrahl hindurchtritt.

Die Erfindung sieht eine Anwendung der teilchenoptischen Vorrichtung in einem Lithographiesystem oder/und einem Mikroskopiesystem vor.

Ausführungsformen der Erfindung werden nachfolgend anhand von Zeichnungen erläutert. Die Ausführungsformen der Figuren 6,7 und 11 bis 13 bitreffen keine Beispiele der Erfindung. Hierbei zeigt

Figur 1    eine räumliche aufgebrochene Darstellung einer Kammlinse, wie sie bei Ausführungsformen der Erfindung einsetzbar ist,

Figur 2    eine schematische Darstellung von Feldverläufen zur Erläuterung der in Figur 1 dargestellten Kammlinse,

Figur 3    eine schematisch räumliche aufgebrochene Darstellung eines Verlaufs eines Teilchenstrahls durch eine Kammlinse, welche auf den Strahl fokussierend wirkt,

Figur 4    eine schematisch räumliche aufgebrochene Darstellung eines Verlaufs eines Teilchenstrahls durch eine Kammlinse, welche auf den Strahl ablenkend wirkt,

Figur 5    eine schematische Darstellung einer Kammlinse, welche in deren Öffnung magnetische Felder erzeugt,

Figuren 6a, 6b, 6c    Erläuterungen zu Hauptkomponenten und Korrekturkomponenten von an Fingerelektroden der in den Figuren 1 bis 3 gezeigten Kammlinsen anzulegenden Spannungen zur Erzeugung eines Quadrupolfeldes,

Figur 7    ein schematischer Verlauf einer Hilfsfunktion zur Bestimmung von Korrekturkomponenten der Figur 6,

Figur 8    eine Elektronenmikroskopievorrichtung gemäß einer Ausführungsform der Erfindung,

Figur 9    eine Darstellung eines Potentialverlaufs einer Kammblende der Mikroskopievorrichtung gemäß Figur 8,

Figur 10    eine Elektronenlithographievorrichtung gemäß einer Ausführungsform der Erfindung,

Figur 11    Graphen zur Erläuterung von weiteren möglichen Korrekturfunktionen,

Figur 12    Graphen von an Fingerelektroden in einem einfachen idealisierten Modell anzulegenden Spannungen,

Figur 13    Graphen von Korrekturspannungen im Hinblick auf ein praxisgerechtes Modell,

Figur 14    der Figur 12 entsprechende Graphen von anzulegenden Spannungen in dem praxisgerechten Modell, und

Figur 15    ein weiteres Beispiel eines Potentialverlaufes entlang einer Mittelachse einer Kammblende gemäß Figur 9.

In den nachfolgend beschriebenen Ausführungsformen sind hinsichtlich ihrer Funktion und ihres Aufbaus einander entsprechende Komponenten weitgehend mit jeweils gleichen Bezugzeichen versehen. Zum Verständnis der Eigenschaften der jeweiligen Komponenten in einer bestimmten Ausführungsform können deshalb auch die Beschreibungen anderer Ausführungsformen einfach herangezogen werden.

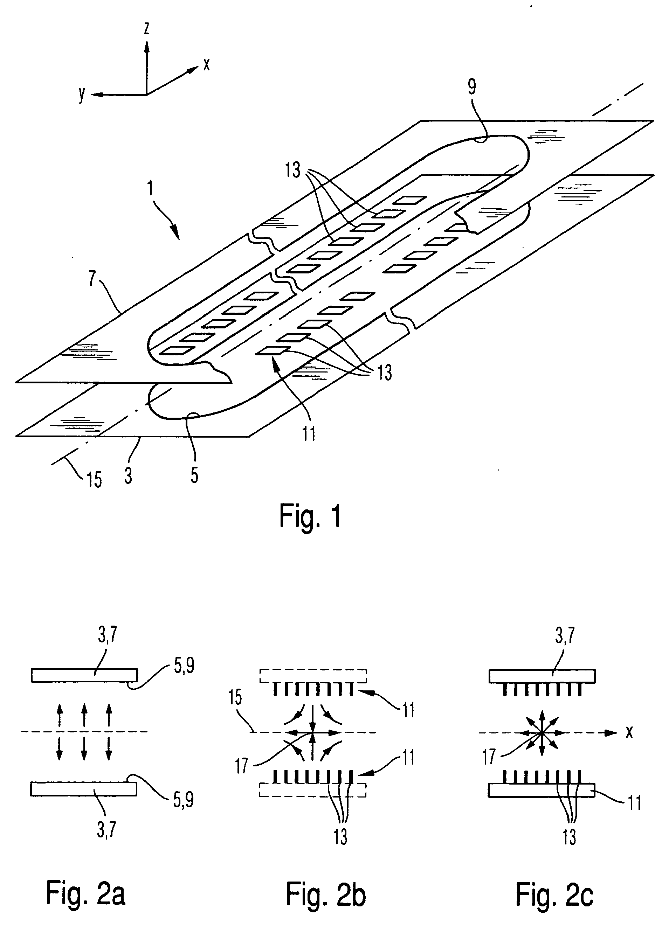

Eine teilchenoptische Vorrichtung 1, wie sie im Zusammenhang mit der Erfindung einsetzbar ist, ist in Figur 1 in aufgebrochener perspektivischer Darstellung schematisch gezeigt.

Diese umfaßt drei in z-Richtung übereinander angeordnete Blenden, nämlich zuunterst eine Blendenelektrode 3 mit einer in x-Richtung langgestreckten Öffnung 5, eine in z-Richtung zuoberst angeordnete Blendenelektrode 7 mit einer ebenfalls in x-Richtung langgestreckten Öffnung 9 sowie einer zwischen den beiden Blendenelektroden 3 und 7 angeordneten Kammblende 11. Die Kammblende 11 umfaßt zwei Reihen von Quellelementen für elektrische Felder, nämlich Fingerelektroden 13, welche beidseits einer in x-Richtung sich erstreckenden Mittelachse 15 der Kammblende 11 angeordnet sind. Die beiden Reihen aus Fingerelektroden 13 begrenzen damit in y-Richtung einen Raum oberhalb bzw. unterhalb der Öffnungen 5 bzw. 9 in den Blendenelektroden 3 und 7, so daß dieser Raum ebenfalls als eine Öffnung der Kammblende 11 betrachtet werden kann.

Den beiden Blendenelektroden 3 und 7 sowie den Fingerelektroden 13 werden durch eine in Figur 1 nicht dargestellte Steuerung elektrische Potentiale zugeführt, so daß zwischen den Elektroden 3, 7 und 13 einstellbare elektrische Felder erzeugt werden können. Diese wirken auf einen Strahl elektrisch geladener Teilchen, welcher quer zur xy-Ebene orientiert ist und die Öffnungen der Blenden 7, 11 und 5 durchsetzt. Liegt an den Blendenelektroden 3 oder 7 ein elektrisches Potential an, welches von dem Potential des Strahls geladener Teilchen in der Ebene der Blendenelektroden 3, 7 abweicht, so wirken die Blendenelektroden 3 bzw. 7 auf den Strahl wie eine Zylinderlinse. Ein Verlauf der elektrischen Feldlinien, wie er von einer solchen Blendenelektrode 3, 7 erzeugt wird, ist in Figur 2a schematisch dargestellt.

An die Fingerelektroden 13 der Kammblende 11 kann ein Potentialmuster derart angelegt werden, daß sich in der Öffnung der Blendenelektrode 11 ein quadrupolähnliches elektrisches Feld einstellt. Ein Verlauf von Feldlinien eines solchen Quadrupolfeldes ist in Figur 2 schematisch dargestellt, wobei das Feld eine Symmetrieachse 17 aufweist, die sich in z-Richtung erstreckt und die Längsachse 15 der Kammblende 11 schneidet.

Ein Strahl elektrisch negativ geladener Teilchen, der in dieses Quadrupolfeld eintritt, wird in x-Richtung fokussiert und in y-Richtung defokussiert.

Tritt ein Strahl somit entlang der Symmetrieachse 17 des Quadrupolfeldes in die Strahlumformungsanordnung 1 ein, so erfährt er insgesamt die Wirkungen der durch die Blendenelektroden 3 und 7 bereitgestellten Zylinderlinsenfelder gemäß Figur 2a sowie des durch die Kammblende 11 bereitgestellten Quadrupolfelds gemäß Figur 2b. Der Strahl erfährt somit eine Überlagerung der in den Figuren 2a und 2b dargestellten Feldkonfigurationen, und bei geeigneter Abstimmung der Stärken der Zylinderlinsenfelder und des Quadrupolfeldes aufeinander ergibt sich auf den Strahl eine gleiche Wirkung wie die eines Rundlinsenfeldes, dessen Feldlinien in Figur 2c schematisch dargestellt sind.

Es ist somit möglich, einen Strahl geladener Teilchen mit der Strahlumformungsanordnung 1 bei geeigneter Beaufschlagung der Elektroden 3, 7 und 13 zu fokussieren.

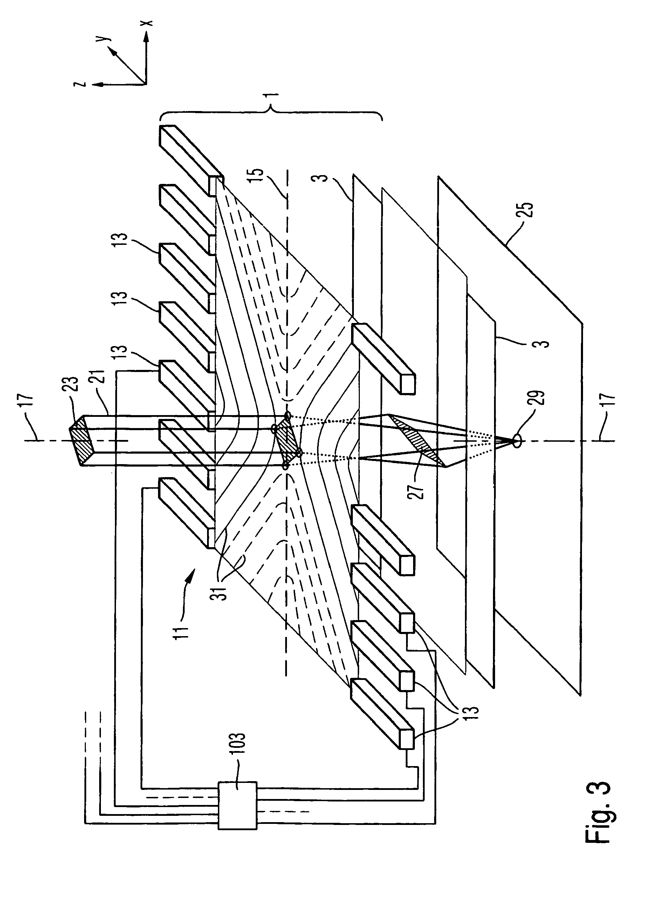

Dies ist in Figur 3 nochmals in räumlicher Darstellung erläutert: Ein Strahl 21 geladener Teilchen mit einem quadratischen Querschnitt 23 tritt entlang einer Symmetrieachse 17 und in z-Richtung in eine Strahlumformungsanordnung 1 ein. Diese umfaßt eine Kammblende 11 mit zwei Reihen Fingerelektroden 13 und eine darunterliegende Blendenelektrode 15. Unterhalb der Blendenelektrode 15 ist eine Objektebene 25 angeordnet, in der der Strahl 21 fokussiert werden soll.

An die Fingerelektrode 13 ist von einer Steuerung 103 ein derartiges Potentialmuster angelegt, daß in der Öffnung zwischen den Reihen Fingerelektroden 13 ein elektrisches Quadrupolfeld entsteht, dessen Verlauf in Figur 3 durch elektrische Potentiallinien 31 angedeutet ist. Das Quadrupolfeld fokussiert den Strahl 21 in x-Richtung und defokussiert denselben in y-Richtung. Entsprechend nimmt der Strahlquerschnitt nach Durchlaufen der Kammblende 11 eine Gestalt einer in y-Richtung langgestreckten Raute 27 in der Ebene der Blendenelektrode 15 an. Die Blendenelektrode 15 wirkt auf den Strahl allerdings wie eine Zylinderlinse, welche den Strahl 21 in y-Richtung fokussiert, so daß dieser schließlich in der Objektebene 25 auf einen kleinen Fleck 29 fokussiert ist.

In Figur 1 sind zur Erzeugung des Zylinderlinsenfeldes zwei Blendenelektroden 3 bzw. 7 vorgesehen, während in Figur 3 zur Erzeugung des Zylinderlinsenfeldes lediglich eine Blendenelektrode 3 vorgesehen ist. Es ist jedoch auch möglich, das Zylinderlinsenfeld durch die Kammelektroden 13 selbst bereitzustellen, indem deren mittleres Potential auf einen Wert eingestellt wird, der von dem Potential des Strahls 21 in der Ebene der Kammelektrode abweicht. Damit stellen die Fingerelektroden 13 im Mittel das Zylinderlinsenfeld bereit, und durch ortsabhängige Änderungen der Potentiale der Fingerelektroden 13 wird das zugehörige Quadrupolfeld bereitgestellt.

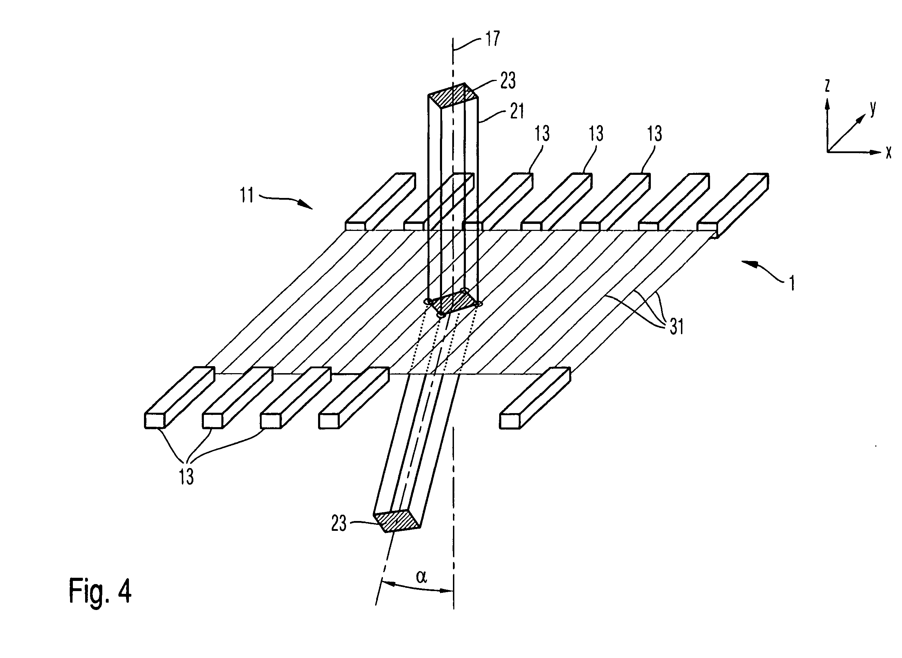

In Figur 4 ist ein Betriebsmodus einer Kammblende 11 dargestellt, der von dem in Figur 3 gezeigten Betriebsmodus zum Fokussieren eines Strahls geladener Teilchen abweicht. In Figur 4 werden die Fingerelektroden 13 durch eine in Figur 4 nicht dargestellte Steuerung derart mit Potentialen beaufschlagt, daß in einer Öffnung zwischen den beiden Reihen von Fingerelektroden 13 ein im wesentlichen homogenes und in x-Richtung orientiertes elektrisches Feld entsteht, dessen Potentiallinien 31 in Figur 4 schematisch eingezeichnet sind. Ein entlang einer in z-Richtung orientierten Strahlachse 17 in die Kammblende 11 eintretender Strahl 21 geladener Teilchen mit quadratischem Querschnitt 23 wird durch das in der Öffnung zwischen den beiden Reihen aus Fingerelektroden 13 gebildete im wesentlichen homogene elektrische Feld in x-Richtung um einen Winkel $\alpha$ abgelenkt, wobei der Querschnitt 23 des Strahls im wesentlichen unverändert bleibt.

Hiermit ist es möglich, die Kammblende 11 als Strahlablenker einzusetzen. Insbesondere kann das den Strahl 21 ablenkende Feld entlang der x-Richtung in der Öffnung zwischen den beiden Reihen Fingerelektroden 13 lokal in einer Umgebung des Strahls 21 bereitgestellt werden, d.h. das elektrische Feld muß sich nicht über die gesamte Länge der Kammblende 11 in x-Richtung erstrecken.

Ferner ist es möglich, die Betriebsmoden der Figuren 3 und 4 zu kombinieren, indem die Fingerelektroden 13 derart mit Potentialen beaufschlagt werden, daß in der Öffnung zwischen den Elektrodenreihen eine Überlagerung des Quadrupolfeldes gemäß Figur 3 und des homogenen Feldes gemäß Figur 4 bereitgestellt ist. Eine derart angesteuerte Kammblende wirkt dann als fokussierender Strahlablenker.

In den vorangehenden beschriebenen Figuren 1 bis 4 wirken die Fingerelektroden 13 jeweils als Quellelemente für das durch die Kammblende 11 bereitgestellte elektrische Feld zur Einwirkung auf den Teilchenstrahl 21.

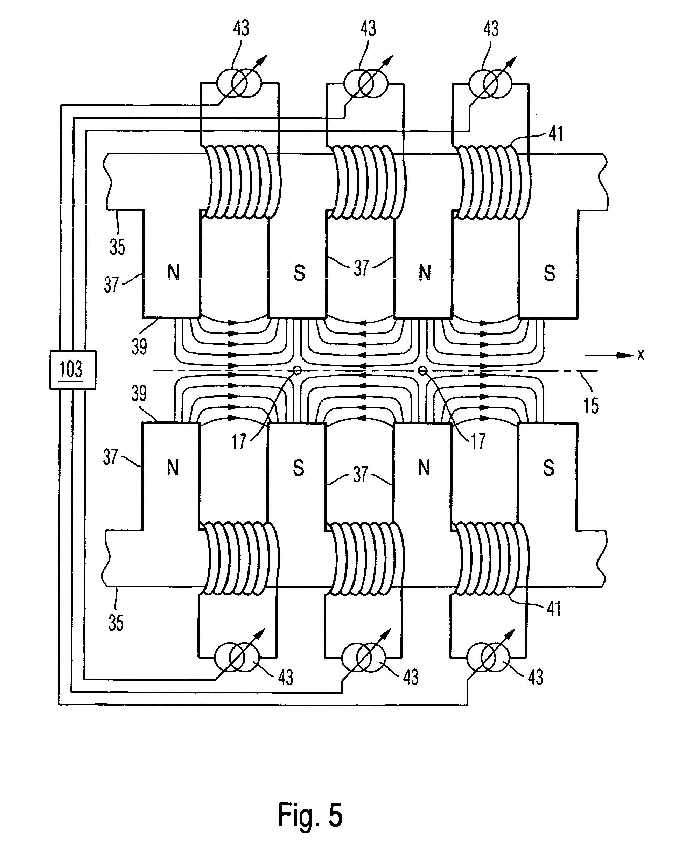

Alternativ ist es jedoch auch möglich, in einer Öffnung einer Kammblende magnetische Felder zum Einwirken auf den Teilchenstrahl bereitzustellen. Eine Realisierung einer solchen Kammblende ist in Figur 5 schematisch dargestellt. Die dort gezeigte Kammblende 11 umfaßt zwei Materialstäbe 35, die sich beidseits einer Mittelachse 15 in x-Richtung erstrecken und von denen eine Reihe von Materialfingern 37 in Richtung zu der Mittelachse 15 abstehen. Die Materialfinger 37 sind mit Abstand voneinander angeordnet und weisen jeweils eine zu der Mittelachse 15 hinweisende Stirnfläche 39 auf. Zwischen jeweils zwei benachbarten Materialfingern 37 ist um die Materialstäbe 35 eine Wicklung 41 aus einem elektrisch leitenden Draht gewickelt. Zur Speisung einer jeden Wicklung mit elektrischem Strom ist für eine jede Wicklung eine durch eine in Figur 5 nicht dargestellte Steuerung ansteuerbare Stromquelle 43 angeschlossen, um einer jeden Wicklung 41 einen Strom einstellbarer Stromstärke zuzuführen. Die Stromleiterwicklungen 41 erzeugen dann Magnetfelder, welche u.a. von dem Materialstab 35 und den Materialfingern 37 geführt werden. In Figur 5 ist an die Wicklungen 41 ein Strommuster derart angelegt, daß benachbarte Wicklungen 41 jeweils Magnetfelder entgegengesetzter Orientierungen erzeugen. Hierdurch entsteht in einer Öffnung der Kammblende 11 eine Magnetfeldkonfiguration, wie sie in Figur 5 mit Feldlinie 45 schematisch dargestellt ist. Die Feldkonfiguration ist näherungsweise die von mehreren entlang der Mittelachse 15 benachbart zueinander angeordneten Quadrupolfeldern mit mit Abstand voneinander angeordneten Symmetrieachsen 17.

Das die Materialstäbe 35 und Materialfinger 37 bereitstellende Material ist vorzugsweise ein Material hoher magnetischer Permeabilität, wie beispielsweise Ferritmaterial.

Es ist auch möglich, magnetische und elektrische Kammblenden in einer Bauanordnung zu kombinieren, in dem beispielsweise die Materialfinger 37 metallisiert werden, um diese als Elektroden auszubilden, denen einstellbare elektrische Potentiale zugeführt werden können. Es ist dann möglich, in der Öffnung zwischen den beiden Reihen von Fingern elektrische und magnetische Felder zu überlagern, um auf Strahlen geladener Teilchen einzuwirken.

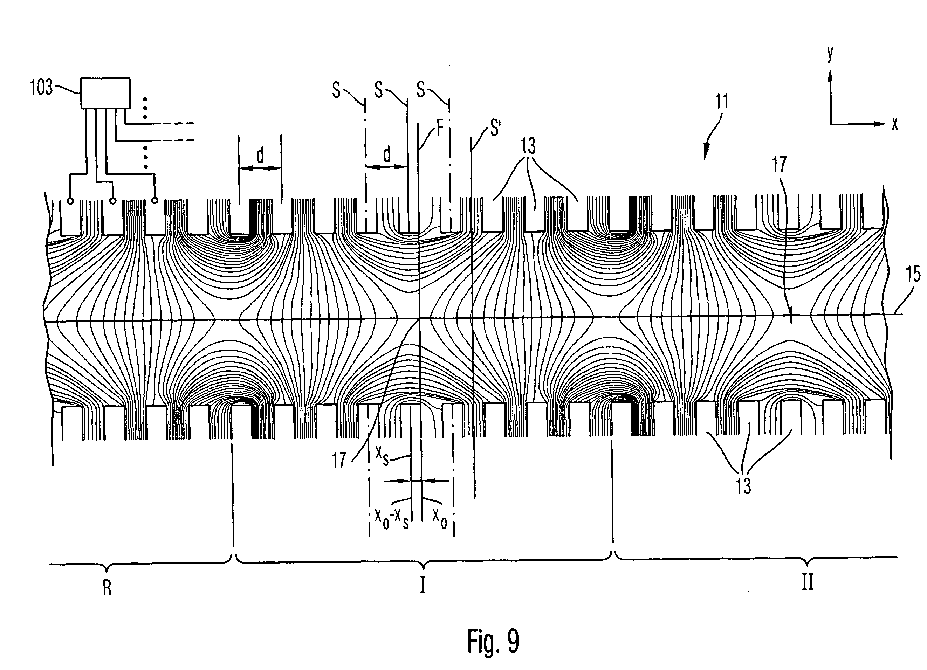

Figur 9 zeigt eine Kammblende 11 mit einer Vielzahl von Fingerelektroden 13, welche Quellelemente für elektrische Felder sind. In Figur 9 sind zwei Feldbereiche I und II dargestellt. In einem jeden der Feldbereiche I und II ist ein quadrupolähnliches Feld bereitgestellt, Äquipotentiallinien dieser Felder sind in Figur 9 eingetragen.

Rechts neben dem in Figur 9 unvollständig gezeigten Feldbereich II schließt sich noch ein Feldbereich III an, der in Figur 9 ebenfalls nicht dargestellt ist.

Das quadrupolähnliche Feld in dem linken Feldbereich I weist eine quer zu einer Längsachse 15 der Kammlinse 11 orientierte Feldsymmetrieebene F auf. Die Fingerelektroden 13 der beiden Reihen von Fingerelektroden sind jeweils einander gegenüberliegend angeordnet, und es existiert ein Satz von Symmetrieebenen S, bezüglich welchen die Fingerelektroden 13 beider Reihen symmetrisch angeordnet sind und welche jeweils ein Paar von sich gegenüberliegenden Fingerelektroden 13 durchsetzen. Es sei angemerkt, daß neben dem in Figur 9 eingetragenen Satz von Symmetrieebenen S, welche die Fingerelektroden 13 durchsetzen, noch ein weiterer Satz von Symmetrieebenen existiert, von denen in Figur 9 eine exemplarisch mit s' bezeichnet ist und welche zwischen einander benachbarten Fingerelektroden 13 angeordnet sind.

Der Ort in x-Richtung, an dem die Feldsymmetrieebene F des Bereichs I angeordnet ist, kann mit $x_0$ bezeichnet werden, welcher die Verlagerung des quadrupolartigen Feldes in x-Richtung angibt. $x_S$ bezeichnet nun den Ort in x-Richtung, an dem die der Feldsymmetrieebene F nächstliegende Symmetrieebene S der Kammelektroden 11 angeordnet ist. Dies ist in Figur 9 die links neben der Feldsymmetrieebene F angeordnete Symmetrieebene S, welche mit durchgezogener Linie angegeben ist. Die weiteren in Figur 9 mit strichpunktierter Linie angegebenen Symmetrieebenen S sind weiter entfernt von der Feldsymmetrieebene F angeordnet. Der Abstand zwischen der Feldsymmetrieebene F und der nächstliegenden Symmetrieebene S ist mit $(x_0 - x_S)$ bezeichnet.

Die Steuerung 103 ist nun dazu ausgebildet bzw. programmiert, daß die in Figur 9 dargestellte Feldkonfiguration in x-Richtung verlagerbar ist, so daß sich der Abstand $(x_0 - x_S)$ ändert.

Nachfolgend wird beschrieben, nach welchem Verfahren die an die Fingerelektroden 13 anzulegenden Spannungen bestimmt werden, um eine Verlagerung des Feldmusters herbeizuführen, ohne daß sich der Feldlinien- bzw. Äquipotentiallinienverlauf der Felder, abgesehen von einer Translation in x-Richtung, stark ändert.

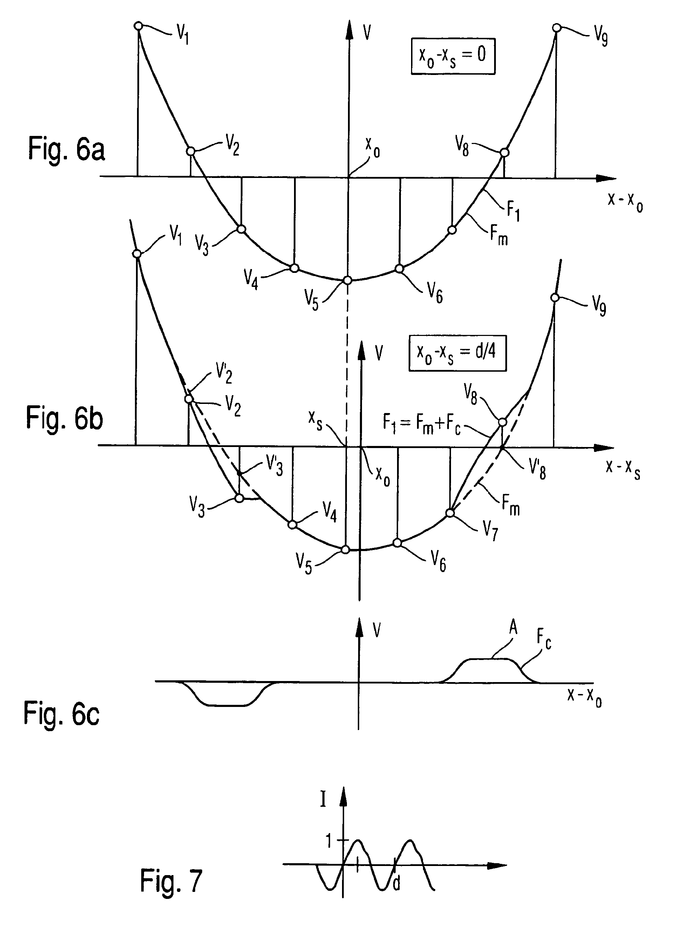

Figur 6a zeigt eine Situation, in der der Abstand $x_0 - x_S$ den Wert Null aufweist. Es ist nach rechts der Abstand von der Feldsymmetrieebene F in x-Richtung aufgetragen, und nach oben eine an die Fingerelektroden 13 anzulegende Spannung V.

Eine kontinuierliche Funktion $F_1$ definiert das an die Fingerelektroden anzulegende Spannungsmuster in der Situation $(x_0 - x_S)$ gleich Null und weist zur Erzeugung eines Quadrupolfeldes einen parabelförmigen Verlauf auf. Wenn die einzelnen Fingerelektroden mit einem Index i versehen sind, so sind die an die einzelnen Fingerelektroden anzulegenden Spannungen $V_i$ definiert durch

$$V_i = F_1(x_i - x_0) \, ,$$

wobei $x_i$ einen Ort der i-ten Fingerelektroden in Reihenrichtung angibt. Das an die Fingerelektroden anzulegende Spannungsmuster entsteht somit aus einer Diskretisierung der kontinuierlichen Funktion $F_1$. In der in Figur 6a dargestellten Situation sind die Fingerelektroden symmetrisch bezüglich der Feldsymmetrieebene F angeordnet, so daß auch das an die Elektroden anzulegende Spannungsmuster symmetrisch bezüglich $x = x_0$ ist.

In Figur 6b ist eine Situation dargestellt, in der, ähnlich wie in Figur 9, die Feldsymmetrieebene F bezüglich der in Figur 6a gezeigten Situation nach rechts verlagert ist, und zwar um einen Betrag, der einem Viertel eines Abstands d zwischen einander benachbarten Fingerelektroden entspricht.

In Figur 6b ist eine Funktion $F_m$ eingetragen, welche den gleichen parabelförmigen Verlauf aufweist, wie die Funktion $F_1$ in Figur 6a, allerdings im Vergleich zu dieser um den Betrag d/4 in x-Richtung verlagert ist. Die Funktion $F_m$ ist eine Hauptkomponente der Funktion $F_1$, welche die an die Fingerelektroden anzulegenden Spannungen $V_i$ definiert.

Es ist weiter noch eine Korrekturkomponente $V_c$ für die Funktion $F_1$ vorgesehen, welche in Figur 6c graphisch dargestellt ist. Die Funktion $F_1$ genügt der Formel

$$F_1(x) = F_m(x) + F_c(x) \, .$$

Aus Figur 6b ist ersichtlich, daß die Spannungen $V_2$, $V_3$ und $V_8$ durch den Einfluß der Korrekturkomponenten $F_c$ geändert sind gegenüber einem Fall, in dem die Spannungen lediglich durch den Verlauf der Hauptkomponente $F_m$ definiert sind. In Figur 6b sind die Potentiale der Fingerelektroden, welche von der Korrekturkomponeten $F_c$ beeinflußt sind, geändert von einem Wert $V_2'$ auf einen Wert $V_2$ bzw. $V_3'$ auf einen Wert $V_3$ und von einem Wert $V_8'$ auf einen Wert $V_8$.

Der Einfluß der Korrekturkomponente $F_c$ auf das Spannungsmuster kann wie folgt verstanden werden:

In der in Figur 6a gezeigten Situation sind die an die Fingerelektroden angelegten Spannungen $V_i$ symmetrisch bezüglich der Feldsymmetrieebene F. Es gilt hier $V_4 = V_6$, $V_3 = V_7$, $V_2 = V_8$ und $V_1 = V_9$. Dies ist in Figur 6b nicht der Fall. Hier gilt $V_4 > V_6$, $V_3' > V_7$, $V_2' > V_8'$ und $V_1 > V_9$. Somit stellt die Kammlinse 11 ein dem Quadrupolfeld überlagertes Dipolfeld bereit.

Dieses überlagerte Dipolfeld macht sich allerdings in einer Äquipotentialliniendarstellung in der Ebene, bezüglich der die Fingerelektroden 13 in z-Richtung symmetrisch angeordnet sind, insbesondere für einen Teilchenstrahl, der die Vorrichtung entlang der Symmetrieachse 17 des Quadrupolfeldes durchsetzt, vergleichsweise wenig bemerkbar. Aus Figur 6b ist ersichtlich, daß ein Unterschied in den Spannungen, welche an bezüglich der Feldsymmetrieebene F bzw. der nächstliegend angeordneten Symmetrieebene S sich paarweise gegenüberliegende Fingerelektroden angelegt werden, umso größer ist, je weiter die Elektroden von den Ebenen F bzw. S entfernt sind. So ist etwa ein Unterschied zwischen den Spannungen $V_4$ und $V_6$ kleiner als ein Unterschied zwischen den Spannungen $V_1$ und $V_9$. Somit sind die Beiträge der entfernt von der Feldsymmetrieebene F angeordneten Paare von Fingerelektroden auf die Dipolwirkung größer als die der näher an der Ebene F angeordneten Paare von Fingerelektroden. Allerdings wird die Dipolwirkung der entfernt von der Ebene F angeordneten Fingerelektroden in der Ebene der Fingerelektroden durch die dazwischenliegenden Fingerelektroden abgeschirmt, weshalb die Dipolwirkung in der Ebene der Fingerelektroden vergleichsweise gering ist. Dies ist allerdings in einiger Entfernung in z-Richtung von dieser Ebene der Fingerelektroden anders. Betrachtet von einem in z-Richtung weit entfernt von der Ebene der Fingerelektroden angeordneten Ort sind sämtliche Fingerelektroden 13 in etwa gleich weit entfernt. Somit tragen sämtliche Fingerelektroden im wesentlichen gleich zu dem Dipolfeld bei, so daß dessen Wirkung in größerer Entfernung in z-Richtung von der Ebene der Fingerelektroden vergleichsweise höher ist als in der Ebene der Fingerelektroden.

Die Korrekturfunktion $F_c$ ist nun derart gewählt, daß eine lediglich kleine Anzahl von Fingerelektroden mit Korrekturspannungen derart beaufschlagt wird, daß diese beaufschlagten Elektroden ein die vorangehend geschilderte Dipolwirkung kompensierendes Dipolfeld bereitstellen. Diese Fingerelektroden sind entfernt von der Symmetrieebene F angeordnet, so daß deren Wirkung in der Ebene der Fingerelektroden und im Bereich der Symmetrieebene F ebenfalls vergleichsweise geringer ist als außerhalb dieser Ebene. Somit hat die Korrekturfunktion $F_c$ für kleine Werte von $(x - x_0)$

Werte von nahezu Null und für Abstände von $x_0$, welche größer sind als 2mal bis 3mal d, wird $F_c$ ungleich Null. Hierbei ist $F_c$ bezüglich $(x - x_0)$ gleich Null unsymmetrisch, um die Dipolwirkung zu erzeugen.

Die Größe der Korrekturkomponente hängt somit von dem Abstand $(x_0 - x_S)$ ab. Für $(x_0 - x_S)$ gleich Null werden keine Korrekturen vorgenommen (vergleiche Figur 6a), mit langsam größer werdenden Werten von $(x_0 - x_S)$ werden die Korrekturen zunehmen. In einem Fall, in dem die Feldsymmetrieebene F mittig zwischen zwei Symmetrieebenen S der Kammlinse 11 angeordnet ist, liegt wiederum eine Symmetrie der Fingerelektroden bezüglich der Feldsymmetrieebene F vor, und die Korrekturen werden dann wiederum nahezu Null sein.

Ein einfaches Verfahren zur Ermittlung der Korrekturen $F_c$ ist nun anhand von Figur 7 erläutert. Die Funktion $F_c$ wird geschrieben als

$$F_c(x) = I(x_0 - x_S) \cdot A(x) \, .$$

Der Verlauf der Funktion A gibt den Verlauf der Korrekturfunktion in Abhängigkeit von $(x - x_0)$ wieder und ist gleich dem Verlauf der Funktion $F_c$ in Figur 6c. Der Term I gibt eine Modulation der Korrekturfunktion $F_c$ an und hat einen in Figur 7 gezeigten Verlauf. Daraus ist ersichtlich, daß die Korrekturen bei Werten von $(x_0 - x_S)$ gleich Null das Vorzeichen wechseln, und die Korrekturen bei kontinuierlicher Verlagerung des Feldes in x-Richtung eine Periode aufweisen, die gleich der Periode der Fingerelektroden ist.

Bei der vorangehend anhand der Figuren 6, 7 und 9 erläuterten Ausführungsform wird in einem Bereich zwischen den Fingerelektroden ein Quadrupolfeld bereitgestellt, welches in x-Richtung verlagert wird. Es ist jedoch auch möglich, zwischen den Fingerelektroden andere Feldtypen bereitzustellen, welche von dem Feldtyp des Quadrupolfeldes abweichen.

Es ist denkbar, das Quadrupolfeld, welches in x-Richtung verlagerbar sein soll, mit einem anderen, in x-Richtung nicht verlagerbaren Feld zu überlagern. Ein Beispiel hierfür wäre ein Dipolfeld, welches zusätzlich zu einer Fokussierung des die Vorrichtung durchsetzenden Strahls auch noch eine Ablenkung des Strahls hervorrufen soll, wie dies anhand von Figur 4 bereits erläutert wurde. In diesem Fall können die an die Fingerelektroden anzulegenden Spannungen gemäß nachfolgender Formel bestimmt werden:

$$V_i = F_1(x_i - x_0) + F_2(x_i) \, ,$$

wobei $F_1$ die in x-Richtung verlagerbare Intensitätskomponente des Feldes repräsentiert, wie dies vorangehend bereits erläutert wurde, und $F_2(x)$ die stationäre Feldkomponente repräsentiert.

Ferner ist es möglich, daß die in x-Richtung verlagerbare Feldkomponente nicht unbedingt die Quadrupolsymmetrie aufweisen muß. Die verlagerbare Feldkomponente kann auch einen anderen Charakter haben. Auch dann sind die vorangehend geschilderten Überlegungen anwendbar, und es wird nicht lediglich ein an die Fingerelektroden anzulegendes Spannungsmuster einfach in x-Richtung verschoben. Es werden vielmehr die vorangehend erläuterten Korrekturen berücksichtigt, deren Größe mit dem Abstand einer für das Feld charakteristischen Ebene von der nächstliegenden Symmetrieebene der Elektroden moduliert sind.

Neben der vorangehend beschriebenen Dipolwirkung, welche insbesondere für größere Abstände von der Ebene der Fingerelektroden bei Verlagerung der Feldsymmetrieebene F weg von einer der Symmetrieebenen S der Fingerelektroden auftritt, treten auch Abweichungen höherer Ordnung auf. Um auch solche Abweichungen höherer Ordnung zu kompensieren, reicht eine Korrektur im Sinne eines Dipolfeldes, wie es anhand der Figuren 6 und 7, insbesondere Figur 6c, erläutert wurde, nicht aus. Es werden dann an die Fingerelektroden Spannungen derart angelegt, daß neben dem beschriebenen Dipolfeld auch noch Felder höherer Ordnung, beispielsweise Hexapolfelder, erzeugt werden.

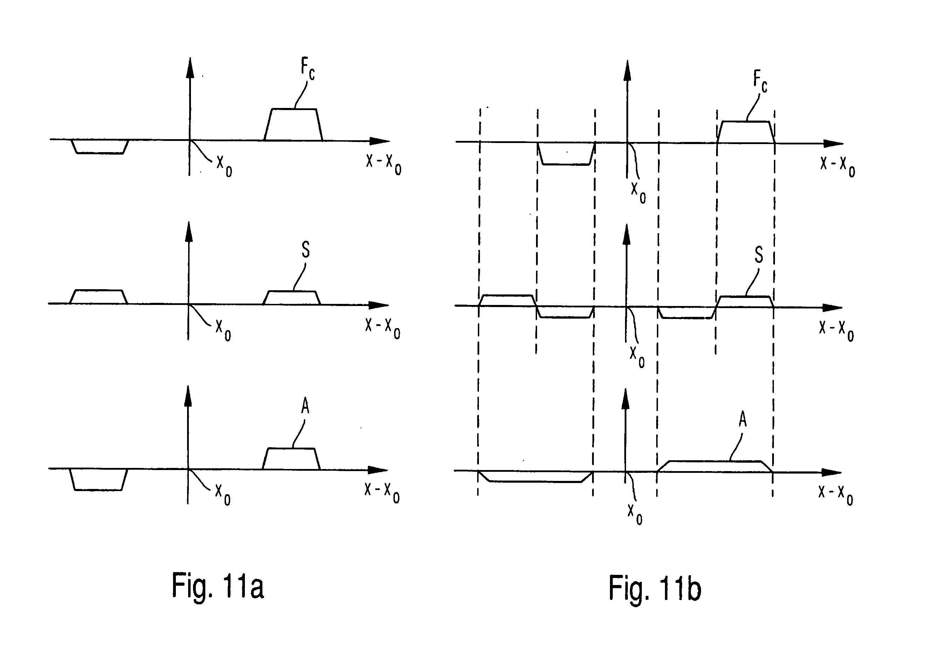

Hierzu zeigt Figur 11a eine Variante einer Abwandlung der vorangehend anhand der Figur 6c erläuterten Korrekturfunktion $F_c$. $F_c$ wird nun bestimmt nach der Gleichung

$$F_c(x) = I_a(x_0 - x_S) \cdot A(x) + I_s(x_0 - x_S) \cdot S(x) \, .$$

Darin ist $S(x)$ eine von $x_0$ im wesentlichen unabhängige und in x symmetrische Funktion und $A(x)$ eine von $x_0$ im wesentlichen unabhängige und in x asymmetrische Funktion.

$I_a$ und $I_s$ sind entsprechende Modulationen der symmetrischen Korrekturfunktion S bzw. der asymmetrischen Korrekturfunktion A. Hierbei weist die Modulation $I_a$ einen Verlauf auf, der ähnlich dem in Figur 7 gezeigten Verlauf ist, das heißt für Auslenkungen, die mit einer Symmetrieebene zusammen fallen, auf welcher ein Feldquellelement bzw. eine Elektrode angeordnet ist, verschwindet die asymmetrische Komponente der Korrekturfunktion $F_c$.

Figur 11b zeigt eine weitere Variante einer Korrekturfunktion $F_c$, bei der ebenfalls an dem Ort $x_0$ ein Dipolfeld erzeugt wird, allerdings durch Feldquellelemente, welche unterschiedlich weit entfernt von $x_0$ beidseits von $x_0$ in der Reihe angeordnet sind. Auch eine solche Funktion $F_c$ kann aus einer symmetrischen Funktion S und einer asymmetrischen Funktion A zusammengesetzt werden. Auch hier ist die Modulation für die asymmetrische Komponente A derart gewählt, daß diese für $(x_0 - x_s) = 0$ verschwindet.

Vorangehend wurden die Quellstärken der Feldquellelemente analytisch bestimmt, indem die Quellstärken im Bezugssystem des verlagerten Feldes berechnet wurden, das heißt, es haben sich damit auch die Orte der einzelnen Quellelemente im Bezugssystem verschoben. Ein Verständnis für die Erfindung kann allerdings auch erreicht werden, indem die Orte der Feldquellelemente für die Korrekturen im Bezugssystem festgehalten werden und die Felder darin verlagert werden, wie dies nachfolgend erläutert wird.

Es wird dabei beispielhaft in der Ausführungsform ausgegangen von einer Geometrie, in der Fingerelektroden in einer Reihe in einem Abstand von 1 mm voneinander angeordnet sind, und wobei jeweils neun Elektroden dazu eingesetzt werden, um ein verlagerbares Quadrupolfeld zwischen den Reihen von Fingerelektroden zu erzeugen.

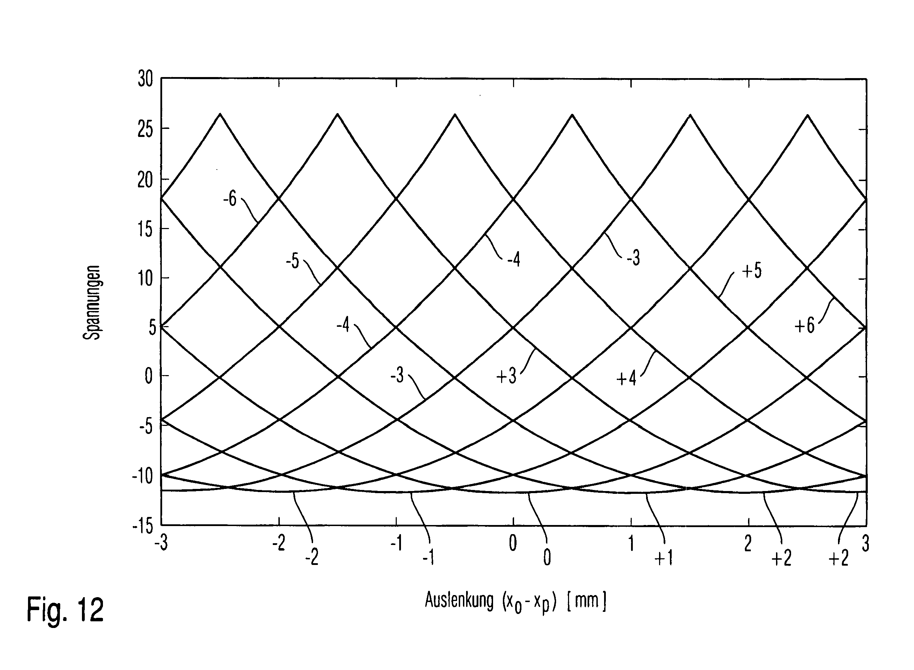

Werden an eine solche Konfiguration von Fingerelektroden elektrische Spannungen zunächst ohne Berücksichtigung von Korrekturen angelegt, so haben diese Spannungen einen in Figur 12 dargestellten Verlauf in Abhängigkeit von einer Auslenkung $(x_0 - x_p)$, wobei $x_p$ der Ursprung des festgehaltenen Koordinatensystems ist und so gewählt wurde, daß es mit einer der Symmetrieebenen S (oder S') der Reihe der Fingerelektroden zusammenfällt.

Bei einem Auslenkungswert $(x_0 - x_p) = 0$, bei dem die Symmetrieachse des Quadrupolfeldes mit einer Symmetrieebene S zusammenfällt, auf der eine Fingerelektrode angeordnet ist, lassen sich aus Figur 12 die an die Elektroden anzulegenden Spannungen wie folgt ablesen:

Die Elektrode, die bei $x_p$ angeordnet ist, trägt den Index '0'. Die Elektrode, die rechts neben der Elektrode '0' angeordnet ist, trägt den Index '+1', und die Elektrode, die links neben der Elektrode '0' angeordnet ist, trägt den Index '-1'. Die links bzw. rechts neben diesen Elektroden '-1', '+1' angeordneten Elektroden tragen die Indizes '-2' bzw. '+2' usw. über '-3' bzw. '+3' bis '-4' bzw. '+4'. Bei der Auslenkung $(x_0 - x_p)=0$ liegen an den Elektroden '-4' bis '+4' zur Erzeugung eines Quadrupolfeldes mit einer Stärke $1,00$ V/mm$^2$ folgende Spannungen an:

**Tabelle 1**

| Elektrode | -4 | -3 | -2 | -1 | 0 | +1 | +2 | +3 | +4 |
|---|---|---|---|---|---|---|---|---|---|
| Spannung [V] | +18,47 | +5,21 | -4,26 | -9,94 | -11,83 | -11,83 | -4,26 | +5,21 | +18,47 |

Diese Werte ergeben sich durch Ablesen der Ordinatenwerte der mit '-4' bis '+4' indizierten Graphen in Figur 12 bei $x_0 - x_p = 0$.

Für von Null verschiedene Auslenkungen ergeben sich die Spannungen entsprechend, wobei in Figur 12 auch Spannungsverläufe für über die Elektroden '-4' bis '+4' hinaus benachbarte Elektroden eingetragen sind.

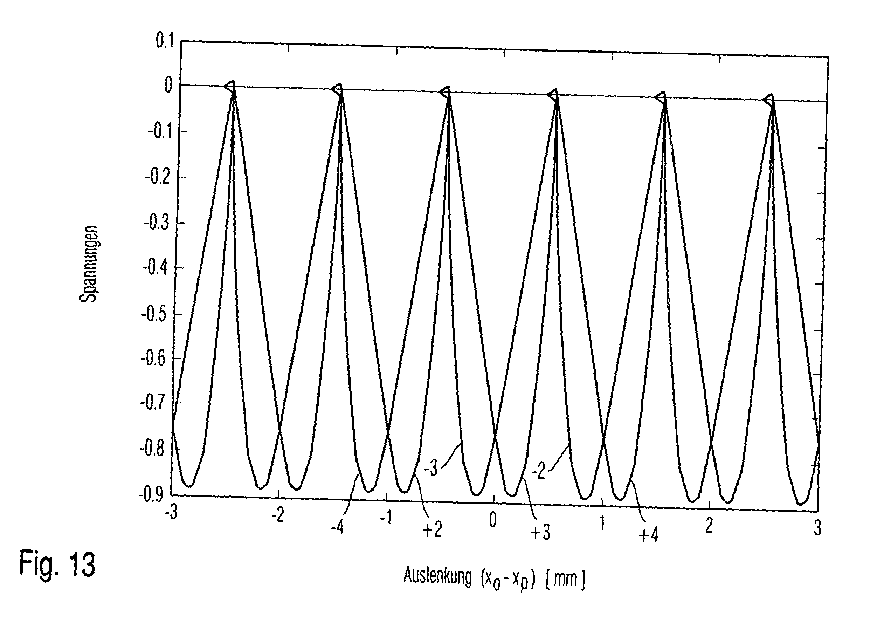

Die in Figur 12 eingetragenen Kurven weisen in Abhängigkeit von der Auslenkung einen parabelförmigen Verlauf auf, was ein idealer Verlauf wäre, um ein Quadrupolfeld zu erzeugen. Allerdings wird dieses ideale Quadrupolfeld aufgrund der Diskretisierung durch die mit 1 mm Abstand voneinander angeordneten Fingerelektroden für Auslenkungen, die von Lagen von Symmetrieachsen S verschieden sind, in der Realität aber nicht erreicht, wie dies vorangehend bereits erläutert wurde. Deshalb werden an ausgewählte Elektroden Korrekturspannungen angelegt, wie dies nachfolgend anhand von Figur 13 weiter erläutert wird. Für Auslenkungen $x_0 - x_p < 0,5$ mm werden die Elektroden '-3' und '+3' für das Anlegen von Korrekturspannungen ausgewählt, die übrigen Elektroden werden nicht korrigiert.

Bei einer Auslenkung von Null werden auf die gemäß Figur 12 bestimmten Spannungen Korrekturspannungen addiert, welche für die Elektroden '-3', '+3' jeweils -0,75 V betragen. Damit sind für beide Elektroden '-3' und '+3' die Korrekturspannungen gleich groß, weshalb die Elektroden '-3' und '+3' für sich kein Dipolfeld erzeugen. Allerdings dient der durch die beiden Elektroden '-3' und '+3' erzeugte Gleichanteil der Korrekturspannung zur Kompensation eines Hexapolfeldes, das zum Teil durch den symmetrischen Anteil der Korrektur erzeugt wird.

Für zunehmende Auslenkungen wird dann die an die Elektrode '+3' anzulegende Spannung stärker negativ und die an die Elektrode '-3' anzulegende Spannung größer. Entsprechend erzeugen diese beiden Elektroden '-3' und '+3' ein korrigierendes Dipolfeld. Für eine Auslenkung von 0,5 mm, das heißt eine Auslenkung, bei der die Symmetrieachse des Quadrupolfeldes mit einer Symmetrieebene der Reihe zusammenfällt, welche zwischen zwei unmittelbar benachbarten Fingerelektroden angeordnet ist, verschwinden die anzulegenden Korrekturspannungen zu Null, so daß auch wieder das korrigierende Dipolfeld verschwindet und auch der Gleichanteil der Korrektur verschwindet. Für Auslenkungen größer 0,5 mm werden dann die zur Korrektur ausgewählten Fingerelektroden "weitergeschaltet", das heißt es werden die vorangehend mit '-2' bzw. '+4' indizierten Elektroden zum Anlegen der Korrekturspannungen ausgewählt, wobei die für weitere Auslenkungen ($x_0$ - $x_p$) von 0,5 mm bis 1,5 mm an die Elektroden '-2'und '+4' anzulegenden Spannungsmuster gleich sind mit den Spannungsmustern, die an die Elektroden '-3' und '+3' für Auslenkungen von -0,5 mm bis +0,5 mm angelegt werden. Für weiter zunehmende Auslenkungen oberhalb 1,5 mm werden die für die Korrektur ausgewählten Elektroden entsprechend weitergeschaltet. Ebenso ist dies für Auslenkungen unterhalb -0,5 mm entsprechend der Fall.

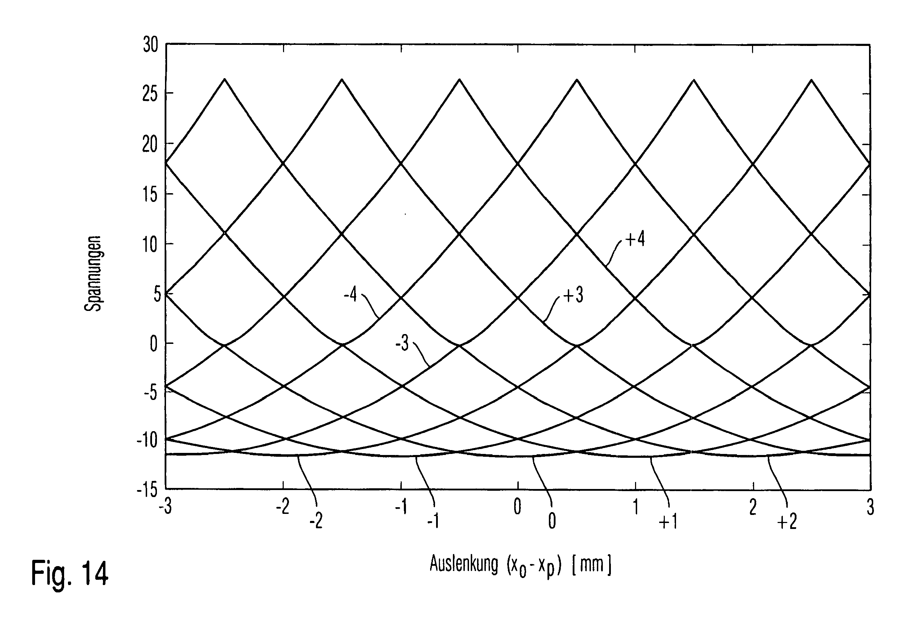

In Figur 14 sind dann die Verläufe der an die Elektrode anzulegenden korrigierten Spannungen dargestellt, welche sich als eine Summe ergeben aus den idealen Verläufen gemäß Figur 12 und den Korrekturen gemäß Figur 13.

In der Ausführungsform gemäß den Figuren 12, 13 und 14 sind beidseits einer mit '0' indizierten mittleren Elektrode lediglich zwei Elektroden (die Elektroden '-3' und '+3') zum Anlegen von Korrekturspannungen ausgewählt. Es ist jedoch auch möglich, hierzu größere Gruppen von Elektroden beidseits der Mittelelektrode auszuwählen.

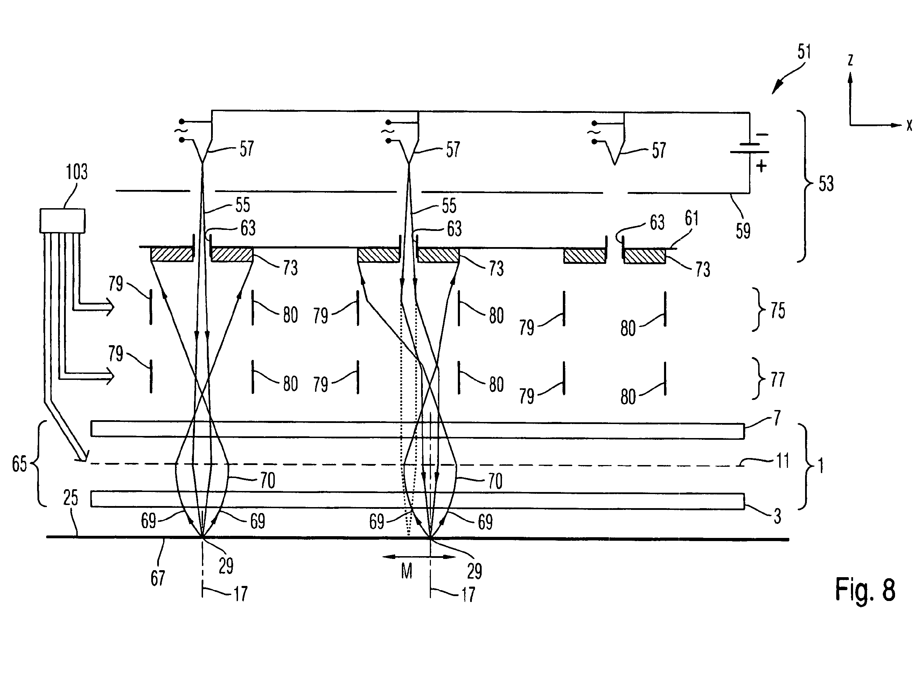

In Figur 8 ist eine Rasterelektronenmikroskopievorrichtung 51 schematisch dargestellt. Diese umfaßt eine Strahlungsquellenanordnung 53 zur Erzeugung einer Mehrzahl von Primärelektronenstrahlen 55 mit einer Mehrzahl von Glühkathoden 57 zur Emission von Elektronen, eine Anode 59 zur Extraktion der Elektronen aus den Glühkathoden 57 sowie eine Aperturblende 61 mit einer Mehrzahl Blendenöffnungen 63 zur Formung der mehreren Strahlen 55. In Figur 8 ist die Anordnung 51 zur Bereitstellung von drei Elektronenstrahlen 55 dargestellt. Es ist jedoch möglich, lediglich einen, zwei oder mehr als drei Strahlen entsprechend bereitzustellen.

Die Mikroskopievorrichtung 51 umfaßt weiter eine Objektivanordnung 65 zur Fokussierung der Primärelektronenstrahlen 55 in eine Objektebene 25, in der ein zu untersuchendes Objekt, wie beispielsweise ein Halbleiterwafer 67 angeordnet ist. Aus dem Objekt 67 löst der darauf fokussierte Primärelektronenstrahl 55 (Sondenstrahl) Sekundärelektronen aus, deren Bewegung in Figur 8 durch einige exemplarische Bahnen 69 dargestellt ist. Die Sekundärelektronen werden durch ein geeignetes zwischen der Objektivanordnung 65 und dem Objekt 67 angelegtes elektrisches Feld beschleunigt und zu Strahlen 70 geformt, welche die Objektivanordnung durchsetzen und auf unterhalb der Aperturblende 61 angeordnete Detektoren 73 treffen.

Zwischen den Detektoren 73 und der Objektivanordnung 65 sind nacheinander eine erste Ablenkeranordnung 75 und eine zweite Ablenkeranordnung 77 vorgesehen. Die Ablenkeranordnungen 75 und 77 umfassen für einen jeden Primärenelektronenstrahl 55 ein Paar von Ablenkelektroden 79 und 80, welchen von einer Steuerung 103 elektrische Potentiale zugeführt werden, um zwischen einem Elektrodenpaar 79, 80 ein elektrisches Feld zur Ablenkung des Primärelektronenstrahls 55 zu erzeugen. In dem in Figur 8 links dargestellten Strahl 55 liegt bei beiden Ablenkeranordnungen 75 und 77 jeweils keine Spannung an den Elektroden 79, 80 an, so daß die Ablenkeranordnungen 75 und 77 von dem linken Primärelektronenstrahl 55 geradlinig durchsetzt werden.

Bei dem in Figur 8 in der Mitte dargestellten Primärelektronenstrahl 55 liegt an den Elektroden 79, 80 der oberen Ablenkeranordnung 75 eine elektrische Spannung derart an, daß der Primärelektronenstrahl 55 zunächst um einen Winkel nach rechts abgelenkt wird. An den Elektroden 79, 80 der unteren Ablenkeranordnung 77 liegt eine entgegengesetzte Spannung derart an, daß der Primärelektronenstrahl 55 um einen entsprechenden Winkel derart nach links abgelenkt wird, daß er nach Durchlaufen der Ablenkeranordnung 77 wieder parallel zur z-Achse in Richtung zu der Objektivanordnung 65 verläuft. Somit dienen die beiden Ablenkeranordnungen 75, 77 dazu, den in der Objektebene 25 fokussierten Primärelektronenstrahl 55 in der Objektebene parallel zu verlagern, so daß das Objekt 67 mit dem Sondenstrahl abgetastet werden kann.

Die Objektivanordnung 65 umfaßt eine teilchenoptische vorrichtung 1 wie sie im Zusammenhang mit den Figuren 1 bis 3 erläutert wurde. Diese umfaßt somit eine obere Blendenelektrode 7, eine untere Blendenelektrode 3 und eine dazwischenliegende Blende 11. Fingerelektroden der Kammblende 11 werden durch die Steuerung 103 derart angesteuert, daß für die drei Primärelektronenstrahlen 55 elektrische Felder bereitgestellt werden, wie sie in Figur 9 dargestellt sind. Einem jeden Primärelektronenstrahl 55 ist ein separater Feldbereich zugeordnet, nämlich dem in Figur 8 linken Primärelektronenstrahl 55 der Feldbereiche I der Figur 9, dem mittleren Strahl in Figur 8 der Feldbereiche II der Figur 9 und dem in Figur 8 nicht dargestellten rechten Strahl in Figur 9 ebenfalls nicht dargestellte vorangehend erläuterte Feldbereich III.

Die Primärelektronenstrahlen 55 werden gemeinsam durch entsprechende Ansteuerung der Ablenkanordnungen 75 und 77 in x-Richtung verlagert, wobei die Symmetrieachsen 17 der Quadrupolfelder zusammen mit den Strahlen verlagert werden.

Hierbei werden, um die Feldintensitätsverteilung für einen jeden Strahl möglichst unabhängig von der Auslenkung bzw. einem Abstand ($x_0$ - $x_S$) zu halten, Korrekturterme bei der Errechnung der an die Fingerelektroden 13 anzulegenden Potentiale berücksichtigt, wie dies vorangehend anhand der Figuren 6 und 7 erläutert wurde.

Ergänzend hierzu werden die Fingerelektroden 13 noch derart angesteuert, daß sich auch beidseits neben den für die Fokussierung der Primärelektronenstrahlen notwendigen Feldbereichen I, II und III noch Feldbereiche R befinden, welche ebenfalls Felder bereitstellen, welche eine Quadrupolcharakteristik aufweisen. Damit wird verhindert, daß die in der Reihe von Feldbereichen I, II, III am Ende angeordneten Feldbereiche I und III eine charakteristisch andere Feldverteilung aufweisen als der zentrale Feldbereich II. Es wird somit versucht, eine Periodizität der Feldbereiche über deren Ende hinaus fortzusetzen, so daß auch in den am Rande liegenden Feldbereichen im wesentlichen gleiche Bedingungen herrschen wie in den zentral gelegenen Feldbereichen.

Hierbei ist es allerdings nicht notwendig, einen vollständigen quadrupolartigen Feldbereich bereitzustellen, wie dies für den in Figur 9 links angeordneten Feldbereich R dargestellt ist. Es ist lediglich wesentlich, daß ein dem Feldbereich I naher Bereich des Randbereichs R einen Teil einer Quadrupolcharakteristik bereitstellt.

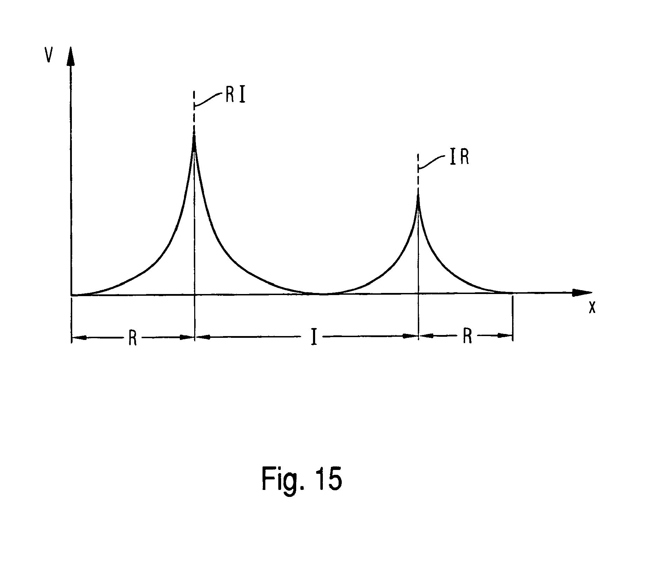

Alternativ zu der vorangehend beschriebenen periodischen Fortsetzung der zur Strahlablenkung benutzten Feldbereiche I, II, III in Bereichen R links und rechts der Reihe von Feldbereichen I, II und III ist es auch möglich, in einem Fortsetzungsbereich R einen Feldverlauf bereitzustellen, welcher spiegelsymmetrisch zu einer am Ende des zur Ablenkung eines Strahls genutzten Feldbereichs verläuft. Dies ist in Figur 15 schematisch dargestellt. In dem Graphen der Figur 15 ist das elektrische Potential V auf der Mittelachse 15 der Blendenelektrode in Abhängigkeit von der Position x dargestellt. Zur Ablenkung eines Strahls wird ein Feldbereich I genutzt. Die Abhängigkeit hat die Gestalt einer Parabel, der eine Gerade überlagert ist. Dies entspricht einem Quadrupolfeld mit einem diesem überlagerten Dipolfeld. Am rechten Ende des Feldbereichs I ist ein Randbereich R vorgesehen, in welchem der Feldverlauf eine Gestalt hat, welche spiegelsymmetrisch ist zu einer Ebene IR, welche sich quer zur x-Richtung erstreckt und am Ende des Feldbereichs I angeordnet ist. Links neben dem Feldbereich I ist ein weiterer Randbereich R angeordnet, in dem das Potential V spiegelsymmetrisch zum Potentialverlauf im Feldbereich I fortgesetzt ist, und zwar bezüglich einer Ebene RI, welche am linken Ende des Feldbereichs I orthogonal zur x-Achse angeordnet ist.

Alternativ zu den vorangehend beschriebenen Möglichkeiten zur Kompensierung von Dipolfeldkomponenten, welche bei Auslenkungen des Feldes weg von den Symmetrieebenen der Reihen entstehen, durch Anlegen von korrigierenden Dipoltermen an die Fingerelektroden selbst, ist es auch möglich, ein entsprechendes kompensierendes Dipolfeld extern von der Kammlinse bereitzustellen. Eine Möglichkeit hierfür bieten beispielsweise die in Figur 8 oberhalb der Kammlinse gezeigten Strahlablenker 77 mit ihren Elektroden 79 und 80, welche schließlich auch ein korrigierendes Dipolfeld bereitstellen können.

Alternativ hierzu ist es auch möglich, die beiden Strahlablenker 75 und 77 so anzusteuern, daß der Strahl unter einem Winkel zur Normalen auf die Ebene der Kammblende auftrifft. Ein dort verbleibendes Dipolfeld wird dann dadurch kompensiert, daß der Strahl durch dieses Feld eine Ablenkung (vergleiche Figur 4) derart erfährt, daß er schließlich auf die Objektebene orthogonal zuläuft. Bei einer kontinuierlich zunehmenden Auslenkung des Ortes 25 in x-Richtung ändert sich dann der Einfallswinkel des Strahls auf die Ebene der Kammlinse periodisch um die z-Achse.

Ferner ist es alternativ hierzu auch möglich, das an die Fingerelektroden anzulegende Spannungsmuster bezüglich $x_0$ zu verlagern, um so ein kompensierendes Dipolfeld zu erzeugen, was schließlich dazu führt, daß ein Zentralstrahl das sich schließlich einstellende Feld in einem Bereich in der Ebene der Kammblende durchsetzt, in der die Feldstärke verschwindet. Wenn der Strahl 17 die Ebene der Fingerelektroden bei $x = x_0$ durchsetzt, werden dann die an die Elektroden anzulegenden Spannungen bestimmt nach der Formel

$$U_i = F_m(x_i - x_0 + \delta x(x_0 - x_s)) + F_2(x_i) \ .$$

Der Term $\delta x$ im Argument der Funktion $F_m$ repräsentiert damit die Verlagerung der Symmetrieachse des angelegten Spannungsmusters relativ zu der Strahlachse 17. Der Term $\delta x$ ist hierbei dann Null, wenn $x_0$ bzw. die Strahlachse mit einer Symmetrieachse der Elektroden zusammenfallen, und er wächst mit zunehmendem Abstand zwischen $x_0$ und der Symmetrieebene an.

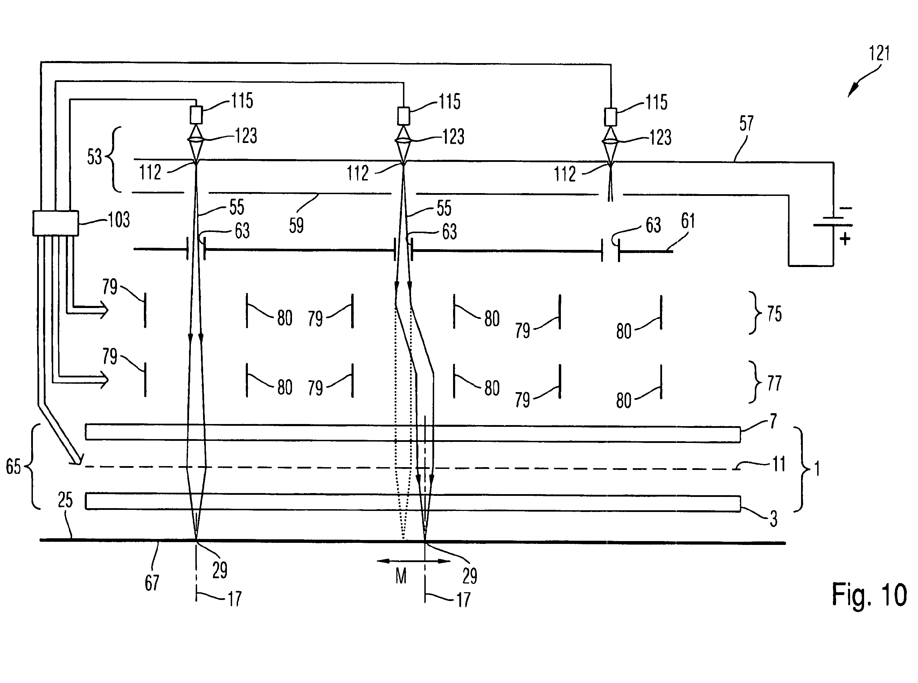

In Figur 10 ist ein Lithographiesystem 121 schematisch dargestellt. Dieses ist hinsichtlich seiner Struktur ähnlich aufgebaut wie die Mikroskopievorrichtung gemäß Figur 8. Allerdings unterscheidet sich das Lithographiesystem 121 hiervon hinsichtlich des Aufbaus einer Strahlungsquellenanordnung 53. Von Lasern 115 emittiertes Licht wird durch Kollimationslinsen 123 fokussiert und auf Vorsprünge 112 einer Anodenplatte 57 gerichtet. Dort werden dann durch photonenunterstützte Feldemission Elektronen ausgelöst, um die Primärelektronenstrahlen 55 zu erzeugen. Im Unterschied zu den Glühkathoden gemäß Figur 8 sind die Elektronenquellen in dem Lithographiesystem gemäß Figur 10 schnell schaltbar, so dass die Primärelektronenstrahlen 55 auch schnell an- und ausschaltbar sind.

In einer Objektebene 25 ist eine Oberfläche eines Wafers 67 angeordnet, welche mit einem teilchenstrahlungsempfindlichen Lack ("resist") beschichtet ist. Durch eine Steuerung 103 werden die Strahlablenker 75 und 77 angesteuert, um die Primärelektronenstrahlen 55 zum Schreiben eines Musters auf dem teilchenempfindlichen Lack über die Objektoberfläche 25 zu bewegen. Hierbei werden die Laser 115 durch die Steuerung 103 ebenfalls angesteuert, um die Strahlen 55 nach Bedarf an- und aus zuschalten.

Auch in dem Lithographiesystem 121 werden die Fingerelektroden derart angesteuert, daß Korrekturen, wie sie anhand der Figuren 6 und 7 erläutert wurden, in die Bestimmung der anzulegenden Potentiale eingehen. Ferner werden auch hier Feldbereiche R (vergleiche Figur 9) neben Feldbereichen vorgesehen, welche einem Schreibstrahl zugeordnet sind, um Randeffekte für am Ende einer Reihe von Schreibstrahlen angeordnete Schreibstrahlen zu verringen.

Bei der anhand der Figur 8 erläuterten Mikroskopievorrichtung und der anhand der Figur 10 erläuterten Lithographievorrichtung wurden jeweils Kammblenden 11 eingesetzt, welche in deren Öffnungen jeweils elektrische Felder bereitstellen. Alternativ hierzu ist es jedoch auch möglich, Kammblenden einzusetzen, die in deren Öffnung magnetische Felder bereitstellen, wie dies anhand der Figur 5 erläutert wurde.

In den Figuren 3 und 4 sind vereinfachte Strahlverläufe und Feldkonfigurationen dahingehend dargestellt, da die Felder schematisch auf eine xy-Ebene beschränkt sind und die Strahlen entsprechend in dieser Ebene einen "Knick" erfahren und außerhalb der Ebene geradlinig verlaufen. In Wirklichkeit sind die Felder jedoch in z-Richtung um die Ebene ausgedehnt, und entsprechend werden die Strahlen ihre Ablenkung nicht als Knick sondern als stetige Kurve erfahren.

Die vorangehend erläuterten Anwendungen beziehen sich auf Elektronenstrahlen, sind jedoch nicht hierauf beschränkt, sondern können auch auf anders geartete Strahlen geladener Teilchen angewendet werden, wie beispielsweise Ionenstrahlen oder Myonenstrahlen usw.

Zusammenfassend wird eine Vorrichtung und ein Verfahren bereitgestellt, um wenigstens einen Strahl geladener Teilchen zu beeinflussen. Die Vorrichtung umfaßt zwei zueinander parallel und mit Abstand voneinander angeordnete Reihen von Feldquellelementen 13, welche in Reihenrichtung periodisch mit Abstand d voneinander derart angeordnet sind, daß Symmetrieebenen S existieren, bezüglich welchen die Feldquellelemente 13 symmetrisch angeordnet sind.

Das Feld weist eine in x-Richtung verlagerbare Komponente auf. Zu deren Bereitstellung wird an die Feldquellelemente ein Quellstärkenmuster gemäß der Formel $F_1(x)=F_m(x)+F_c(x)$ angelegt, wobei $F_m$ eine von der Verlagerung $x_0$ im wesentlichen unabhängige Komponente ist und $F_c$ eine von $x_0$ abhängige Korrekturkomponente ist.

## Patentansprüche

1. Teilchenoptische Vorrichtung (1) zur Beeinflussung von mindestens drei Gruppen je wenigstens eines Strahls (55) geladener Teilchen, wobei die Vorrichtung umfasst:

    eine Strahlungsquellenanordnung (53) zur Erzeugung der Gruppen je wenigstens eines Strahls (55) geladener Teilchen nebeneinander;
    wenigstens eine Reihe von Feldquellelementen (13), wobei in der Reihe die Feldquellelemente (13) in einer Reihenrichtung (x) periodisch und mit Abstand (d) voneinander angeordnet sind; und
    eine Steuerung (103) zum Einstellen von Quellstärken ($V_i$) der Feldquellelemente (13), um neben der Reihe von Feldquellelementen (13) Felder zur Beeinflussung der Strahlen (55) bereitzustellen, wobei die Steuerung (103) die Felder derart bereitstellt, dass einer jeden Gruppe ein erster Feldbereich (I, II, III) zugeordnet ist zur Beeinflussung des wenigstens einen Strahls der Gruppe bezüglich einer innerhalb des zugeordneten ersten Feldbereichs gelegenen optischen Achse, und eine der Anzahl der Gruppen entsprechende Zahl von ersten Feldbereichen (I, II, III) in Reihenrichtung (x) nebeneinander angeordnet sind, wobei die Gruppen jeweils entlang einer Symmetrieachse (17) des zugeordneten Feldbereiches in diesen eintreten;

    **dadurch gekennzeichnet, dass**
    die Steuerung (103) ferner an wenigstens einem Ende der ersten Feldbereiche (I, II, III) und jenseits davon in Reihenrichtung (x) einen zusätzlichen, nämlich gar keinem Strahl geladener Teilchen zugeordneten zweiten Feldbereich (R) bereitstellt, der ein Feld bereitstellt, welches zu einem der Felder der ersten Feldbereiche (I) hinsichtlich Feldintensität und Feldverlauf bezüglich einer sich quer zu der Reihenrichtung (x) erstreckenden und an dem Ende des ersten Feldbereichs (I) angeordneten Ebene (IR) derart spiegelsymmetrisch ist, dass ein Strahl geladener Teilchen an dem Ende der ersten Feldbereiche (I) durch die bereitgestellten Felder im wesentlichen gleich beeinflusst wird wie nicht an dem Ende der ersten Feldbereiche (I, II, III) angeordnete Strahlen geladener Teilchen.

2. Teilchenoptische Vorrichtung gemäß Anspruch 1, wobei der zusätzliche zweite Feldbereich (R) in einem dem benachbarten ersten Feldbereich (I) benachbarten Bereich einen Teil einer Quadrupolcharakteristik bereitstellt.

3. Teilchenoptische Vorrichtung gemäß Anspruch 1, wobei der zusätzliche zweite Feldbereich (R) einen vollständigen quadrupolartigen Feldbereich bereitstellt.

4. Teilchenoptische Vorrichtung gemäß Anspruch 1, umfassend einen weiteren, an dem anderen Ende der ersten Feldbereiche (I, II, III) bereitgestellten zusätzlichen zweiten Feldbereich (R), welcher einen Feldverlauf bereitstellt, welcher spiegelsymmetrisch zu demjenigen an dem anderen Ende des den wenigstens einen Strahl (55) beeinflussenden ersten Feldbereichs (I) verläuft, und zwar bezüglich einer sich orthogonal zu der Reihenrichtung (x) erstreckenden und an dem anderen Ende des ersten Feldbereichs (I) angeordneten Ebene (RI).

5. Lithographiesystem (121) zur Übertragung eines Musters mittels wenigstens eines Schreibstrahls (55) geladener Teilchen auf ein teilchenempfindliches Substrat (67), umfassend die teilchenoptische Vorrichtung (1) nach einem der Ansprüche 1 bis 4.

6. Mikroskopiesystem (51) zur Erzeugung eines teilchenoptischen Abbilds eines Objekts (67), umfassend die teilchenoptische Vorrichtung (1) nach einem der Ansprüche 1 bis 4.

7. Verfahren zum Betreiben einer teilchenoptischen Vorrichtung (1) zur Beeinflussung von mindestens drei Gruppen je wenigstens eines Strahls (55) geladener Teilchen nebeneinander, wobei die Vorrichtung (1) wenigstens eine Reihe von in einer Reihenrichtung (x) periodisch und mit Abstand voneinander angeordneten Feldquellelementen (13) umfasst,
wobei Quellstärken ($U_i$) der Feldquellelemente (13) eingestellt werden, um neben der Reihe von Feldquellelementen (13) Felder zur Beeinflussung der Strahlen (55) bereitzustellen,
wobei einer jeden Gruppe ein erster Feldbereich (I, II, III) zugeordnet ist zur Beeinflussung des wenigstens einen Strahls der Gruppe bezüglich einer innerhalb des zugeordneten ersten Feldbereichs gelegenen optischen Achse, und eine der Anzahl der Gruppen entsprechende Zahl von ersten Feldbereichen (I, II, III) in der Reihenrichtung (x) nebeneinander angeordnet sind, wobei die Gruppen jeweils entlang einer Symmetrieachse (17) des zugeordneten Feldbereiches in diesen eintreten;
**dadurch gekennzeichnet, dass**
an wenigstens einem Ende der ersten Feldbereiche (I, II, III) und jenseits davon in Reihenrichtung (x) ein zusätzliches, nämlich keinem zu beeinflussenden Strahl geladener Teilchen zugeordnetes Feld bereitgestellt wird, das zu einem der Felder der ersten Feldbereiche (I) hinsichtlich Feldintensität und Feldverlauf derart spiegelsymmetrisch ist, dass ein Strahl geladener Teilchen an dem Ende der ersten Feldbereiche (I) durch die bereitgestellten Felder im wesentlichen gleich beeinflusst wird wie nicht an dem Ende der ersten Feldbereiche (I, II, III) angeordnete Strahlen geladener Teilchen.

8. Verfahren nach Anspruch 7, wobei die mehreren Strahlen (55) in der Reihenrichtung (x) verlagert werden und die ersten Feldbereiche (I, II, III) zusammen mit den Strahlen (55) verlagert werden.

9. Verfahren zum Betreiben eines Lithographie- (121) oder eines Mikroskopiesystems (51), umfassend das Verfahren gemäß Anspruch 7 oder 8.

**Claims**

1. A particle-optical apparatus (1) for manipulating at least three groups of at least one beam (55) each of charged particles, the apparatus comprising:

   a beam source arrangement (53) for generating the groups of at least one beam (55) each of charged particles, adjacent to each other;
   at least one row of field source members (13), the field source elements (13) in the row being periodically positioned spaced apart from each other by a distance (8d) in a row direction (x); and
   a controller (103) for setting source strengths ($v_i$) of the field source members (13) to generate, aside the row of field source members (13), fields for manipulating the beam (55), wherein the controller (103) provides the fields such that a first field region (I, II, III) is allocated to each group for manipulating the at least one beam each of the group in respect of an optical axis disposed within the allocated first field region, and a number of first field regions (I, II, III) corresponding to the number of groups are positioned adjacent to each other in row direction (x), said groups entering the allocated field region along an axis of symmetry (17) of the allocated field region;

   **characterized in that**
   the controller (103) further provides at least at one end of the first field region (I, II, III) and beyond same in row direction (x) an additional second field region (R) which is allocated to no beam of charged particles at all and provides a field which is mirror symmetrical to one field of the first field regions (I) as regards field intensity and field profile in respect of a plane which extends transversely to the row direction (x) and disposed at the end of the first field region (I) such that a beam of charged particles at the end of the first field region (I) is substantially equally manipulated by means of the provided fields as compared to beams of charged particles which are not disposed at the end of the first field regions (I, II, III).

2. The particle-optical apparatus according to claim 1, wherein the additional second field region (R) provides a part of a quadrupole characteristic in a region adjacent to said first field region (I).

3. The particle-optical apparatus according to claim 1, wherein the additional second field region (R) provides a complete quadrupole-like field region.

4. The particle-optical apparatus according to claim 1, comprising an additional second field region (R) at the other end of the first field regions (I, II, III), which additional second field region provides a field profile which is mirror symmetrical to that at the other end of the first field region (I) which manipulates the at least one beam (55), namely in respect of a plane (RI) which extends orthogonally to the row direction (x) and is disposed at the other end of the first field region (I).

5. A lithography system (121) for transferring a pattern by means of at least one writing beam (55) of charged particles on a particle-sensitive substrate (67), comprising the particle-optical apparatus (1) according to one of claims 1 to 4.

6. A microscopy system (51) for generating a particle-optical image of an object (67), comprising the particle-optical apparatus (1) according to one of claims 1 to 4.

7. A method for operating a particle-optical apparatus (1) for manipulating at least three groups of at least one beam (55) each of charged particles adjacent to each other, the apparatus (1) comprising at least one row of field source elements (13) disposed periodically spaced apart from each other in a row direction (x),
wherein the source strengths ($U_i$) of the field source elements (13) are set to provide, aside the row of field source members (13), fields for manipulating the beams (55),
wherein a first field region (I, II, III) is allocated to each group for manipulating the at least one beam each of the group in respect of an optical axis disposed within the allocated first field regions, and a number of first field regions (I, II, III) corresponding to the number of groups are disposed in the row direction (x) adjacent to each other, said groups entering the allocated field region along an axis of symmetry (17) of the allocated field region;
**characterized in that**
at least at one end of the first field regions (I, II, III) and beyond same in row direction (x) an additional field is provided which is allocated to no beam of charged particles at all and is mirror symmetrical to one field of the first field regions (I) as regards field intensity and field profile such that a beam of charged particles at the end of the first field region (I) is substantially equally manipulated by means of the provided fields as compared to beams of charged particles which are not disposed at the end of the first field regions (I, II, III).

8. The method according to claim 7, wherein plural beams (55) are displaced in the row direction (x) and the first field regions (I, II, III) are displaced together with the beams (55).

9. A method for operating a lithography system (121) or a microspy system (51), comprising the method according to claim 7 or 8.

**Revendications**

1. Dispositif d'optique à particules (1) destiné à influencer au moins trois groupes d'au moins, chacun, un rayon (55) de particules chargées, dans lequel le dispositif comprend :

   un agencement de source de rayonnement (53) destiné à générer les groupes d'au moins, chacun, un rayon (55) de particules chargées, les uns à côté des autres ;
   au moins une rangée d'éléments de source de champ (13) où, dans la rangée, les éléments de source de champ (13) sont disposés dans une direction de rangée (x), périodiquement et avec un écart (d) entre eux ; et
   une commande (103) permettant de régler les intensités de source ($v_i$) des éléments de source de champ (13) afin de mettre à disposition, près de la rangée d'éléments de source de champ (13), des champs permettant d'influencer les rayons (55), la commande (103) mettant à disposition les champs de façon telle qu'une première zone de champ (I, II, III) est coordonnée à chaque groupe pour influencer ledit au moins un rayon du groupe par rapport à un axe optique placé au sein de la première zone de champ coordonnée, et des premières zones de champ (I, II, III), qui correspondent, en nombre, au nombre de groupes, sont disposées dans la direction de la rangée (x) les unes à côté des autres, les groupes y pénétrant respectivement le long d'un axe de symétrie (17) de la zone de champ coordonnée ;

**caractérisé en ce que**
la commande (103) met en outre à disposition, au niveau d'au moins une extrémité des premières zones de champ (I, II, III) et de chaque côté de celles-ci, dans la direction de la rangée (x), une seconde zone de champ (R) supplémentaire, à savoir coordonnée à aucun rayon de particules chargées, qui met à disposition un champ qui - par rapport à un des champs des premières zones de champ (I), quant à l'intensité de champ et à la configuration du champ, eu égard à un plan (IR) qui s'étend transversalement à la direction de la rangée (x) et est disposé à l'extrémité de la première zone de champ (I) - est en symétrie spéculaire de façon telle qu'un rayon de particules chargées à l'extrémité des premières zones de champ (I) est influencé par les champs mis à disposition de façon essentiellement identique aux rayons de particules chargées qui ne sont pas disposés à l'extrémité des premières zones de champ (I, II, III).

2. Dispositif d'optique à particules selon la revendication 1, dans lequel la seconde zone de champ supplémentaire (R) met à disposition, dans une zone voisine de la première zone de champ voisine (I), une partie d'une caractéristique de quadripôle.

3. Dispositif d'optique à particules selon la revendication 1, dans lequel la seconde zone de champ supplémentaire (R) met à disposition une zone de champ quadripolaire totale.

4. Dispositif d'optique à particules selon la revendication 1, comprenant une autre seconde zone de champ supplémentaire (R), mise à disposition à l'autre extrémité des premières zones de champ (I, II, III), qui met à disposition une configuration de champ qui s'étend, par symétrie spéculaire par rapport à celle de l'autre extrémité de la première zone de champ (I) influençant ledit au moins un rayon (55) et ce eu égard à un plan (RI) qui s'étend orthogonalement par rapport à la direction de la rangée (x) et est disposé à l'autre extrémité de la première zone de champ (I).

5. Système lithographique (121) destiné à la transmission d'un modèle au moyen d'au moins un faisceau (55) de particules chargées sur un substrat sensible aux particules (67), comprenant le dispositif d'optique à particules (1) selon l'une des revendications 1 à 4.

6. Système de microscopie (51) permettant de générer une image par optique des particules d'un objet (67), comprenant le dispositif d'optique à particules (1) selon l'une des revendications 1 à 4.

7. Procédé d'exploitation d'un dispositif d'optique à particules (1) destiné à influencer au moins trois groupes d'au moins, chacun, un rayon (55) de particules chargées les uns à côté des autres, dans lequel le dispositif (1) comprend au moins une rangée d'éléments de source de champ (13) disposés dans une direction de la rangée (x), périodiquement et avec un écart entre eux,
dans lequel les puissances de source ($U_i$) des éléments de source de champ (13) sont réglées pour mettre à disposition, à côté de la rangée des éléments de source de champ (13), des champs permettant d'influencer les rayons (55),
dans lequel est coordonnée, à chaque groupe, une première zone de champ (I, II, III) pour influencer ledit au moins un rayon du groupe par rapport à un axe optique placé au sein de la première zone de champ coordonnée, et dans lequel des premières zones de champ (I, II, III), qui correspondent, en nombre, au nombre des groupes, sont disposées dans la direction de la rangée (x) les unes à côté des autres, les groupes y pénétrant respectivement le long d'un axe de symétrie (17) de la zone de champ coordonnée ;
**caractérisé en ce que**
au niveau d'au moins une extrémité des premières zones de champ (I, II, III) et de chaque côté de celles-ci dans la direction de la rangée (x) est mis à disposition un champ supplémentaire, à savoir coordonné à aucun rayon de particules chargées à influencer, qui - par rapport à un des champs des premières zones de champ (I), quant à l'intensité de champ et à la configuration de champ - est en symétrie spéculaire de façon telle qu'un rayon de particules chargées à l'extrémité des premières zones de champ (I) est influencé par les champs mis à disposition de façon essentiellement identique aux rayons de particules chargées qui ne sont pas disposés à l'extrémité des premières zones de champ (I, II, III).

8. Procédé selon la revendication 7, dans lequel les différents rayons (55) sont déplacés dans la direction de la rangée (x) et les premières zones de champ (I, II, III) sont déplacées avec les rayons (55).

9. Procédé d'exploitation d'un système de lithographie (121) ou de microscopie (51) comprenant le procédé selon la revendication 7 ou 8.

Fig. 1

Fig. 2a

Fig. 2b

Fig. 2c

Fig. 3

EP 1 389 796 B1

Fig. 4

EP 1 389 796 B1

Fig. 5

Fig. 6a

Fig. 6b

Fig. 6c

Fig. 7

Fig. 8

Fig. 9

Fig. 10

Fig. 11a

Fig. 11b

Fig. 12

Fig. 13

Fig. 14

Fig. 15

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0122469 A1
- EP 1385192 A2

- US 20010028044 A1

**In der Beschreibung aufgeführte Nicht-Patentliteratur**

- **Schmid et al.** *J. Vac. Sci. Technol. B,* 2001, vol. 19 (6), 2555-2565